# FASCICULE DE BREVET EUROPEEN

(11) **EP 0 395 488 B1**
(45) Date de publication et mention de la délivrance du brevet: **13.07.1994**
(21) Numéro de dépôt: 90401097.2
(22) Date de dépôt: 24.04.1990
(51) Int. Cl.: H01L 21/60, H01L 21/98

(54) **Procédé et machine d'interconnexion de composants électriques par éléments de soudure**
Verfahren and Apparat zum Verbinden elektrischer Bauelemente mittels Lötelementen
Method and apparatus for interconnecting electrical components by solder elements

(30) Priorité: 26.04.1989 FR 8905542
(43) Date de publication de la demande: 31.10.1990
(73) Titulaire: COMMISSARIAT A L'ENERGIE ATOMIQUE, 75015 Paris Cédex 15 (FR)
(72) Inventeur: Boitel, Michelle, F-38400 Saint Martin d'Heres (FR); Marion, François, F-38120 Saint Egreve (FR); Pornin, Jean-Louis, F-38720 St Hilaire de Touvet (FR); Ravetto, Michel, F-38170 Seyssinet Pariset (FR)
(74) Mandataire: Dubois-Chabert, Guy

(56) Documents cités:
- EP-A- 0 002 884
- EP-A- 0 229 850
- EP-A- 0 262 580
- US-A- 4 166 562

## Description

La présente invention concerne un procédé d'interconnexion, par éléments de soudure, de composants électriques ainsi qu'une machine pour la mise en oeuvre de ce procédé. L'invention s'applique notamment dans le domaine de la Microélectronique.

Par "composants électriques" on entend aussi bien des composants électriques actifs tels que les circuits intégrés par exemple, que des composants électriques passifs tels que, par exemple, des substrats de céramique munis de plots de contacts électriques.

L'invention s'applique par exemple à l'hybridation de composants électroniques réalisés sur des substrats de silicium et de composants électroniques réalisés sur des substrats de CdHgTe ou de silicium.

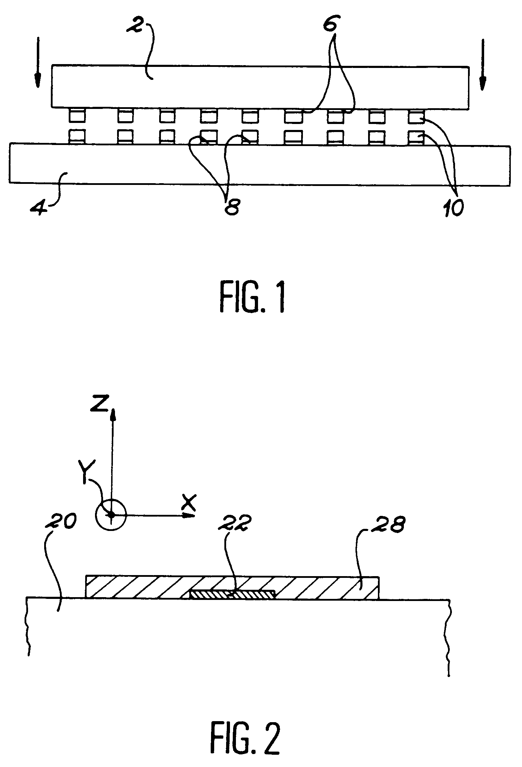

On connaît déjà un premier procédé d'interconnexion de composants électriques, qui est schématiquement illustré par la figure 1. Selon ce procédé, pour interconnecter deux composants 2 et 4, qui comportent respectivement des séries de plots de contact électrique 6 et 8, on munit chaque plot de chaque série d'un élément de soudure 10, on place les deux composants en face l'un de l'autre et on les aligne avec précision l'un par rapport à l'autre de telle manière que chaque élément de soudure de l'un des composants soit en regard de l'élément de soudure correspondant sur l'autre composant. On exerce ensuite une forte pression sur les deux composants mis en contact de sorte que les éléments de soudure, par exemple en Indium, fluent et assurent la liaison électrique entre les deux composants. Pour favoriser ce fluage, il est préférable de ramollir les éléments de soudure à une température qui peut être de l'ordre de 50°C à 80°C. De plus, il est nécessaire d'appliquer une force au moins égale à 1 gramme par plot, de façon homogène sur tous les plots, pour que les deux composants interconnectés puissent supporter les contraintes mécaniques et thermiques qui apparaissent lors de leur utilisation.

Un exemple d'un tel procédé est par exemple décrit dans le document (1) FR-A-2 569 052.

Ce premier procédé connu présente des inconvénients : la solidité du contact entre les éléments de soudure est moyenne malgré les précautions prises quant à la température et à la pression lors de l'hybridation des composants, ce qui se traduit par l'apparition de contacts ouverts lorsque ces composants fonctionnent. Le nombre de points que l'on peut hybrider est limité, en particulier du fait qu'une force de 15 kilogrammes est nécessaire pour l'hybridation d'une matrice de 128 x 128 points, une force de 65 kilogrammes pour l'hybridation d'une matrice de 256 x 256 points. Or, la force limite applicable au moyen des machines appropriées actuellement disponibles est égale à 15 kilogrammes. De plus, le rendement d'hybridation est assez faible, le taux de défauts étant de 10% ; ce rendement est affecté par une répartition inhomogène de pression sur les éléments de soudure, inhomogénéité qui est amplifiée par un défaut de parallélisme entre les composants ou par la non-planéité de ceux-ci, notamment pour les composants de grandes dimensions. Enfin, l'alignement des composants doit être très précis pour avoir un bon rendement d'hybridation.

On connaît également un second procédé d'interconnexion, notamment par le document (2) : l'article de J. MARSHALL et al., publié dans Solid State Technology, Janvier 1979, p.87 à 93.

Selon ce second procédé, les plots des deux composants sont préalablement munis d'éléments de soudure en forme de boule pour l'un des composants et de forme sensiblement plane pour l'autre composant. Le composant portant des plots recouverts d'éléments de soudure en forme de boule est appliqué contre le composant qui doit lui être connecté et qui comporte des plots munis d'éléments de soudure de forme sensiblement plane. Cette mise en contact des composants est réalisée de façon que chaque boule de soudure de l'un des composants soit en regard de la soudure dont est muni le plot correspondant sur l'autre composant. Ensuite, l'assemblage ainsi obtenu est chauffé à la température de fusion de la soudure puis refroidi.

Ce second procédé connu présente également des inconvénients : il s'agit d'un procédé compliqué qui nécessite la réalisation préalable de boules de soudure sur l'un des deux composants avant d'interconnecter ces deux composants. En outre, la soudure est présente sur les deux composants, avant l'interconnexion de ceux-ci.

On connaît aussi, notamment par le document (3) PCT/GB86/00538, (WO-A-8701509), un troisième procédé d'interconnexion de composants électriques.

Ce troisième procédé connu présente aussi des inconvénients :
- Il nécessite la fabrication de plots spéciaux de grande taille pour l'autoalignement lors de l'hybridation de composants électroniques, d'où une perte importante en surface active, limitative pour les connexions de grande densité (matrices...).
- De manière inhérente à ce troisième procédé connu, la distance séparant les deux composants est toujours plus petite que la hauteur de la plus petite des billes permettant l'interconnexion des composants, d'où une limitation en ce qui concerne la tenue lors de cycles thermiques (cette tenue dépendant de la hauteur de la bille en question).
- Ce troisième procédé ne permet pas le rattrapage des défauts de technologie (éléments de soudure non conformes par exemple).
- Ce troisième procédé ne permet pas de compenser les erreurs dues à une forme bombée de certains composants (en particulier dans le cas d'une hybridation de composants de grande taille, WAFER/WAFER par exemple).

La présente invention a pour but de remédier aux inconvénients des procédés connus, mentionnés précédemment, en proposant un procédé d'interconnexion de deux composants électriques, qui permette d'obtenir un contact solide entre les plots des deux composants, qui permette également d'hybrider un grand nombre de points et d'améliorer le rendement d'hybridation et ne nécessite pas une grande précision d'alignement, tout en étant plus simple que le procédé décrit dans le document (2).

De façon précise, la présente invention a pour objet un procédé d'interconnexion d'un premier composant électrique et d'au moins un deuxième composant électrique qui sont respectivement munis de plots de contact électrique destinés à être interconnectés, ce procédé comprenant une étape dans laquelle chaque plot du premier composant est recouvert d'un élément de soudure appelé galette, qui est électriquement conducteur et qui s'étend sur l'environnement dudit plot, ces galettes ayant une épaisseur sensiblement constante et étant faites d'un matériau métallique à bas point de fusion, soudable aux plots du premier composant, ceux-ci étant mouillables par ce matériau à l'état fondu alors que leur environnement sur le premier composant ne l'est pas, ce procédé étant caractérisé en ce que ledit matériau est également soudable aux plots du deuxième composant, en ce que ces derniers plots sont mouillables par ce matériau à l'état fondu alors que leur environnement sur le deuxième composant ne l'est pas et en ce que le procédé comprend en outre les étapes suivantes :
- le premier et le deuxième composants sont mis en contact de telle manière que les galettes du premier composant recouvrent totalement ou partiellement les plots correspondants du deuxième composant,
- l'assemblage des premier et deuxième composants ainsi obtenu est porté à une température permettant la fusion du matériau métallique des galettes, l'un des premier et deuxième composants étant maintenu tandis que l'autre est libre, et
- la température de l'assemblage est ramenée en-dessous de la température de fusion du matériau métallique.

De préférence, les galettes sont sensiblement circulaires.

Dans le cas de telles galettes sensiblement circulaires, la tolérance "d'alignement" de chaque plot sur le plot correspondant est environ égale à plus ou moins un rayon de galette.

Dans la présente invention, on utilise une véritable soudure entre chaque galette et les plots correspondants de sorte que les contacts obtenus ont une excellente solidité. En outre, la présente invention ne nécessite l'application d'aucune force de pression sur les composants et de ce fait, le nombre de points à interconnecter peut être beaucoup plus important que celui qui correspond au premier procédé connu mentionné plus haut. De plus, le rendement d'hybridation est bien supérieur à celui qui est obtenu par ce premier procédé connu, notamment du fait que chaque galette, lorsqu'elle est chauffée à une température qui en permet la fusion, prend sensiblement une forme sphérique qui est en contact avec les plots qui lui correspondent et qu'il s'agit d'interconnecter, puisque ces plots sont mouillables par la soudure à l'état fondu alors que leur environnement ne l'est pas. Enfin, le procédé objet de l'invention nécessite une précision d'alignement beaucoup plus faible que celle qui est nécessaire dans le premier procédé connu mentionné plus haut du fait que dans la présente invention on observe un effet d'auto-alignement des composants, comme on le comprendra mieux par la suite.

Par ailleurs, le procédé objet de l'invention est plus simple que le second procédé connu mentionné plus haut du fait qu'il ne nécessite qu'une seule galette pour chaque couple de plots à interconnecter et ne comporte qu'une seule étape de chauffage.

On notera en outre que dans le second procédé connu, il se produit une déformation des boules, due à leur écrasement, ce qui risque de provoquer un contact entre deux boules proches l'une de l'autre. Un tel risque n'existe pas avec les galettes de la présente invention.

Des applications successives du procédé objet de l'invention peuvent permettre d'obtenir un empilement de plusieurs composants interconnectés : ledit premier composant peut consister en une pile de composants élémentaires préalablement interconnectés par des applications répétées du procédé objet de l'invention et une application supplémentaire de ce procédé permet d'obtenir une pile comportant un composant élémentaire de plus.

Des applications successives du procédé objet de l'invention peuvent aussi permettre d'interconnecter un composant de grande taille et plusieurs autres composants de taille inférieure : ledit premier composant peut être ce composant de grande taille déjà connecté à une pluralité d'autres composants de plus petite taille par des applications répétées du procédé objet de l'invention et une application supplémentaire de ce procédé permet d'augmenter d'une unité le nombre d'autres composants connectés au composant de grande taille.

Selon un mode de mise en oeuvre particulier du procédé objet de l'invention, l'interconnexion est effectuée sur un ensemble de plus de deux composants à la fois, de façon collective, en vue d'obtenir un empilement de ces composants, chaque composant interne de l'empilement étant muni de plots de contact électrique sur ses deux faces, les composants de l'ensemble sont empilés, des galettes faites dudit matériau étant préalablement prévues sur les plots de composants appropriés de l'ensemble, à raison d'une seule galette pour chaque couple de plots à interconnecter, de telle manière que les contacts électriques voulus puissent être établis entre les plots des composants de l'empilement, et cet empilement est porté à ladite température, l'un des composants d'extrémité de l'empilement étant maintenu horizontalement tandis que les autres composants de l'empilement sont libres et se trouvent au-dessus de ce composant d'extrémité.

Selon un autre mode de mise en oeuvre particulier, l'interconnexion est effectuée sur un ensemble de plus de deux composants à la fois, de façon collective, l'un des composants étant destiné à être interconnecté aux autres par l'une de ses faces, l'assemblage des composants est réalisé, des galettes faites dudit matériau étant préalablement prévues sur les plots de composants appropriés de l'ensemble, à raison d'une seule galette pour chaque couple de plots à interconnecter, de telle manière que les contacts électriques voulus puissent être établis entre les plots des composants de l'assemblage, et cet assemblage est porté à ladite température, le composant destiné à être connecté aux autres composants étant maintenu horizontalement tandis que les autres composants de l'assemblage sont libres et se trouvent au-dessus dudit composant.

Selon un mode de mise en oeuvre préféré du procédé objet de l'invention, après la mise en contact des composants jusqu'au refroidissement de ceux-ci en-dessous de la température de fusion du matériau métallique constituant les galettes, l'un des composants est maintenu horizontalement tandis que chaque autre composant est libre et se trouve au-dessus du composant maintenu horizontalement.

De préférence, le matériau métallique est choisi dans le groupe comprenant l'étain, l'indium, le plomb et les alliages métalliques à bas point de fusion, contenant de l'étain, de l'indium ou du plomb.

La présente invention concerne également une machine d'interconnexion d'un premier composant électrique et d'au moins un deuxième composant électrique qui sont respectivement munis de plots de contact électrique destinés à être interconnectés, cette machine étant caractérisée en ce qu'elle comprend :
- des moyens d'approvisionnement en premier et deuxième composants, dans lesquels des galettes électriquement conductrices recouvrent les plots de composants, en débordant sur l'environnement de ces plots, ces composants munis de galettes étant choisis pour qu'il y ait une seule galette pour chaque couple de plots à interconnecter, ces galettes étant faites d'un matériau métallique à bas point de fusion, soudable aux plots des composants, ceux-ci étant mouillables par ce matériau à l'état fondu alors que leur environnement sur les composants correspondants ne l'est pas,
- des moyens de réception des composants interconnectés,
- des moyens d'alignement des composants, prévus pour mettre en contact les galettes de chaque composant choisi avec les plots du composant à connecter à ce composant choisi,
- des moyens de chauffage prévus pour porter l'assemblage que constitue les composants mis en contact à une température permettant la fusion du matériau, et
- des moyens de transfert de composants depuis les moyens d'approvisionnement jusqu'aux moyens de réception en passant par les moyens d'alignement et les moyens de chauffage.

Les moyens d'alignement peuvent comprendre :
- des moyens optiques permettant l'observation des faces de composants, faces qui sont à interconnecter, et
- des moyens de déplacement relatif de ces composants.

Les moyens de chauffage peuvent comprendre un four à passage, destiné à être traversé par les composants mis en contact.

En variante, ces moyens de chauffage peuvent comprendre une table chauffante mobile, prévue pour être appliquée contre l'assemblage des composants puis écartée de cet assemblage.

La présente invention sera mieux comprise à la lecture de la description qui suit, d'exemples de réalisation donnés à titre purement indicatif et nullement limitatif, en référence aux dessins annexés sur lesquels :
- la figure 1, déjà décrite, illustre schématiquement un procédé connu d'interconnexion de composants,
- la figure 2 illustre schématiquement une galette recouvrant un plot avant la réalisation de l'interconnexion de deux composants selon un procédé conforme à l'invention,
- les figures 3A à 3C illlustrent schématiquement différentes étapes d'un mode de mise en oeuvre particulier du procédé objet de l'invention,
- les figures 4A et 4B illustrent schématiquement un avantage de l'invention, à savoir que dans celle-ci, la troncature d'une ou de plusieurs galettes n'est pas gênante,
- les figures 5A à 5C illustrent schématiquement un autre avantage de l'invention, à savoir la non-nécessité d'un positionnement très précis des composants du fait de l'auto-alignement qui se produit lorsqu'ils sont interconnectés conformément à l'invention,
- les figures 6A et 6B illustrent encore un autre avantage de l'invention, à savoir l'obtention d'une interconnexion même lorsque l'un des composants est bombé,
- la figure 7 illustre schématiquement un autre mode de mise en oeuvre particulier du procédé objet de l'invention, conduisant à l'obtention d'une pile de composants interconnectés,
- la figure 8 illustre schématiquement un autre mode de mise en oeuvre particulier du procédé objet de l'invention, conduisant à l'obtention d'interconnexions entre un composant de grande taille et plusieurs autres composants de plus petites tailles, et
- la figure 9 est une vue schématique d'un mode de réalisation particulier de la machine objet de l'invention.

La figure 2 illustre schématiquement la préparation d'un composant 20 préalablement à son interconnexion à un autre composant conformément à la présente invention. Comme on le verra mieux dans ce qui suit, le composant 20, qui comporte des plots conducteurs tels que 22 est muni de galettes 28 qui recouvrent respectivement les plots.

Chaque galette 28 a une épaisseur sensiblement constante suivant l'axe Z perpendiculaire à la surface -supposée plane- du composant 20, qui porte les galettes et la projection de cette galette 28 parallèlement à l'axe Z dans un plan XY perpendiculaire à Z a sensiblement la forme d'un disque.

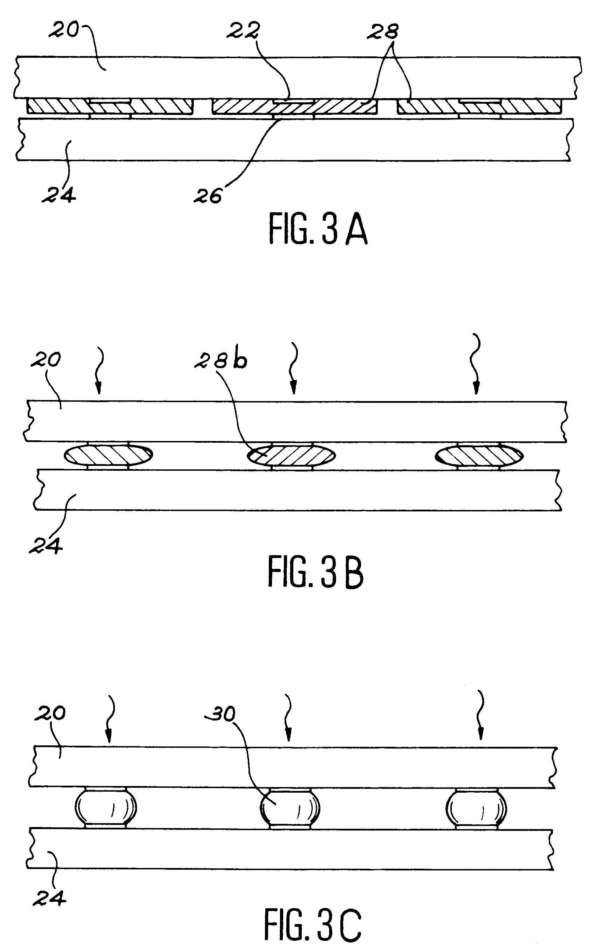

Sur les figures 3A à 3C, on a représenté schématiquement différentes étapes d'un mode de mise en oeuvre particulier du procédé objet de l'invention. Ce mode de mise en oeuvre utilise un matériau tel que l'indium qui, lorsqu'il est liquide, mouille bien certains métaux tel que l'or mais ne mouille pas ou mouille très mal certains isolants tel que la silice ou des matériaux tels que les polyimides.

Bien entendu, on utilise un matériau dont la température de fusion est suffisamment faible pour ne pas détériorer les composants lors de l'interconnexion de ceux-ci conformément à la présente invention. A cet égard, l'indium convient.

Comme on le voit sur la figure 3A, on souhaite interconnecter un composant 20 muni de plots 22 et un composant 24 muni de plots 26 de manière à obtenir des liaisons électriques respectivement entre les plots 22 et 26.

A cet effet, l'un des deux composants, par exemple le composant 20, est muni d'une pluralité de galettes 28 qui sont faits dudit matériau, par exemple l'indium.

Chaque galette 28 recouvre un plot 22 et déborde de celui-ci de sorte qu'elle recouvre également une partie non mouillable du composant 20, partie qui entoure le plot 22 en question.

Les composants 20 et 24 peuvent être des circuits électroniques complexes qui sont munis desdits plots en vue de leur interconnexion.

L'environnement des plots 22 et 26 est par exemple de la silice, non mouillable par ledit matériau à l'état fondu, alors que ces plots 22 et 26, qui sont par exemple en or, sont mouillables par ce matériau à l'état fondu.

A titre purement indicatif et nullement limitatif, lesdites galettes ont un diamètre de l'ordre de 60 micromètres et une épaisseur de l'ordre de 6 micromètres et les plots se présentent sous la forme de couches minces de 25 micromètres de diamètre et d'environ 1 micromètre d'épaisseur et peuvent être disposés en matrice sur les composants avec un pas de 70 micromètres par exemple. A titre indicatif et nullement limitatif, ce pas pourra être aussi petit que 20 micromètres quand le diamètre des galettes sera égal ou inférieur à 15 micromètres.

On réalise les galettes d'indium 28 de telle manière qu'elle soient disjointes les unes des autres, par un procédé connu dans l'état de la technique.

Ensuite, les composants 20 et 24 sont mis au contact l'un de l'autre de telle manière que chaque galette 28 recouvre le plot 26 lui correspondant.

Ceci est réalisable au moyen d'un système optique à double visée comme on le verra mieux par la suite.

L'intervalle séparant alors les composants est égal à l'épaisseur des galettes d'indium.

On procède ensuite à une montée en température de l'ensemble obtenu, jusqu'à la température de fusion de l'indium.

A cette température se produit une répulsion des deux composants, due aux tensions de surface des galettes.

Plus précisément, cette répulsion résulte du fait que, lorsque chaque galette 28 est porté à la température de fusion de l'indium, le volume d'indium prend une forme sphérique et vient se rassembler, se localiser et s'accrocher sur les plots 22 et 26 correspondants, du fait que ces plots 24 et 26 sont mouillables par l'indium alors que l'environnement de ces plots de l'est pas. Il se produit alors un écartement entre les deux composants du fait de la transformation de chaque galette 28 en un élément 30 de forme sphérique (figure 3C), après que cette galette ait pris une forme 28b dilatée perpendiculairement aux composants et contractée parallèlement à ceux-ci (figure 3B).

L'intervalle final qui sépare les deux composants interconnectés (figure 3C) dépend à la fois du volume d'indium initial de chaque galette et de la taille des surfaces mouillables. Dans l'exemple donné ci-dessus à titre purement indicatif et nullement limitatif, l'intervalle final vaut environ 20 micromètres.

L'assemblage des deux composants est ensuite refroidi naturellement.

Pendant le chauffage des composants et jusqu'au refroidissement de ceux-ci, l'un des composants, par exemple le composant 24, est maintenu (il est par exemple posé sur un support horizontal non représenté) tandis que l'autre composant 20 est libre (par exemple au-dessus du composant 24).

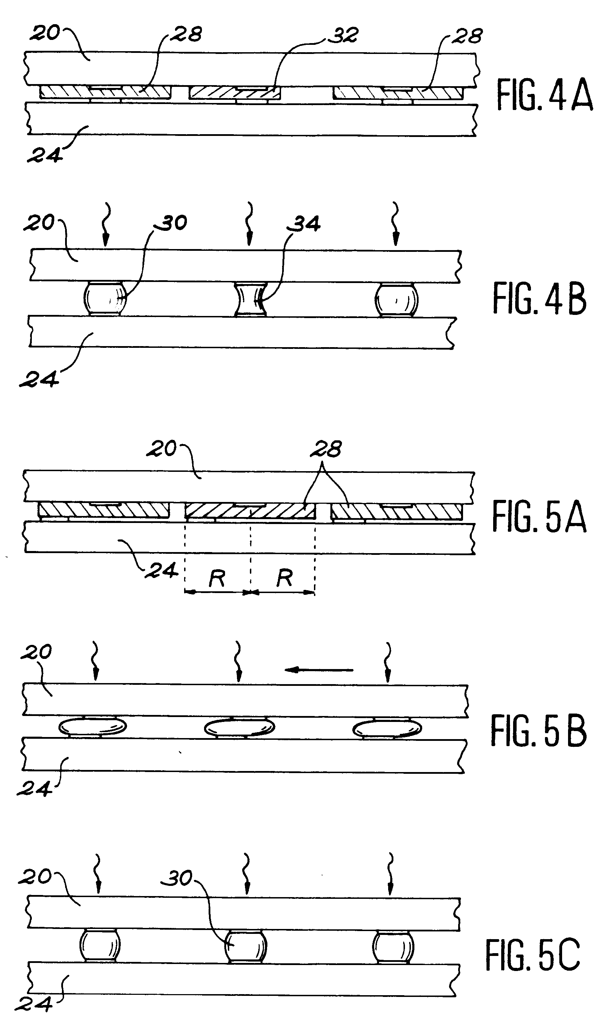

Le procédé décrit en référence aux figures 3A à 3C présente les avantages suivants :
- L'interconnexion réalisée est très résistante puisque une véritable soudure de l'indium sur l'or est réalisée l'arrachement des deux composants permet d'ailleurs de voir que la cassure se produit non pas aux interfaces indium/or mais après étirement et rupture de l'indium.
- L'assemblage obtenu résiste très bien au vieillissement, aux cycles thermiques et aux vibrations et répond aux spécifications spatiales.
- Le rendement d'hybridation est excellent, le nombre de rejets étant voisin de 0. Dans l'exemple décrit en référence aux figures 3A à 3C, les plots ne peuvent être en court-circuit puisque chaque volume d'indium se "contracte" pour être en contact uniquement avec les plots correspondants. Les figures 4A et 4B illustrent d'ailleurs schématiquement un avantage du procédé décrit en référence aux figures 3A à 3B par rapport aux trois procédés connus, mentionnés plus haut : avec ces derniers, une galette d'indium tronquée donnera fréquemment un circuit ouvert alors qu'avec le procédé décrit en référence aux figures 3A à 3C, on n'obtient jamais un circuit ouvert sauf dans le cas du manque total d'un galette, une galette d'indium tronquée 32 (figure 4A) donnant finalement un volume d'indium 34 (figure 4B) plus petit que les autres puisque la galette d'indium correspondante est plus petite que les autres galettes, mais permettant tout de même l'interconnexion des plots correspondants.
- L'indium n'est déposé que sur un seul des composants à hybrider.
- La mise en oeuvre du procédé conforme à l'invention provoque un phénomène d'auto-alignement des composants et nécessite de ce fait une précision d'alignement plus faible que celle qui est nécessaire avec le premier procédé connu mentionné plus haut : chaque galette d'indium doit simplement recouvrir la surface mouillable correspondante sur l'autre composant (figure 5A).

On voit que, pour des galettes circulaires de rayon R (figure 5A), la tolérance de positionnement d'un plot sur le plot correspondant est de l'ordre de ±R.

Etant donné un alignement initial imparfait, lorsque l'indium atteint son point de fusion, l'effet mécanique provoqué d'un part par l'accrochage de l'indium sur l'autre composant et d'autre part par la transformation du volume d'indium provoque l'auto-alignement des deux composants, à savoir un déplacement du composant qui est libre par rapport au composant qui est maintenu par exemple sur un support horizontal (figure 5B), pour aboutir à une position des deux composants dans laquelle l'alignement est correct (figure 5C).

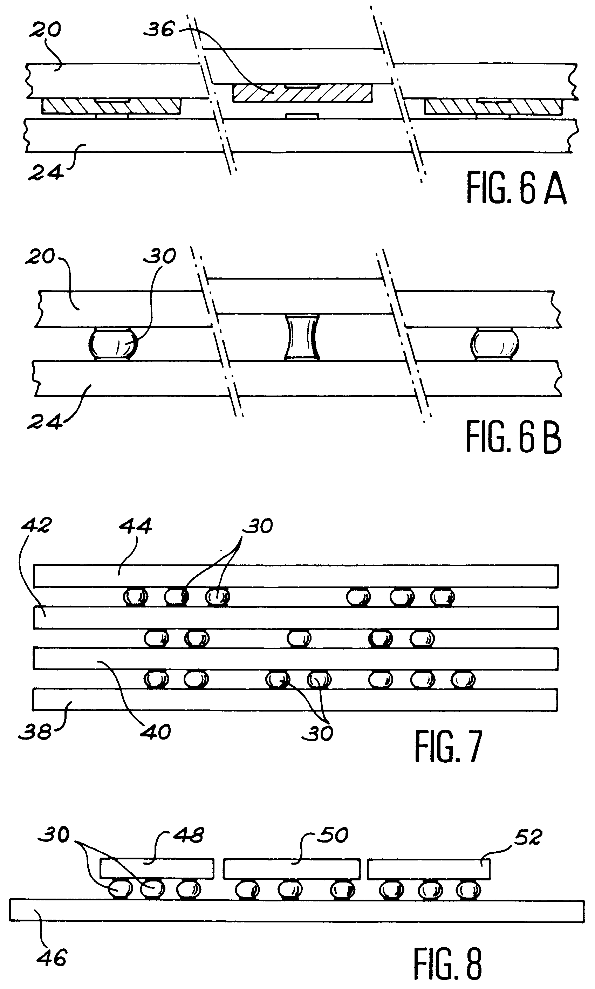

Le procédé objet de l'invention est particulièrement bien adapté à l'hybridation de grandes surfaces à grande densité de points à interconnecter. En effet, de par son principe, l'invention permet de tolérer les défauts de concavité que présentent actuellement les substrats tels que les tranches de silicium de grande taille sans que l'on soit obligé de maintenir les énormes pressions qui sont nécessaires dans le premier procédé connu mentionné plus haut. Du fait de ce défaut de concavité, certaines galettes d'indium 36 peuvent ne pas être initialement en contact avec les plots qui leurs correspondent sur l'autre composant 24 (figure 6A), mais après la fusion de l'indium et le changement de forme du volume d'indium correspondant à chaque galette 36 qui résulte de ce changement de forme, le contact électrique est tout de même obtenu avec le plot correspondant sur l'autre composant 24 (figure 6B).

La surface de chaque composant peut aller de 1 millimètre carré environ jusqu'à plusieurs centaines de centimètres carrés. On notera que l'intérêt de l'invention augmente avec l'accroissement de la surface des composants à interconnecter du fait que la concavité mentionnée plus haut augmente avec cette surface.

La taille des galettes en indium peut aller de quelques micromètres à une centaine de micromètres.

La distance entre deux galettes en indium adjacentes peut être d'environ 2 micromètres ou plus.

La densité de ces galettes n'est pas limitée, sous réserve de choisir un pas de ces galettes qui soit compatible avec la taille de celles-ci.

La présente invention permet également de réaliser une structure dans laquelle plusieurs composants 38, 40, 42, 44 sont empilés et interconnectés (figure 7), soit en répétant plusieurs fois le procédé objet de l'invention pour connecter le composant 40 au composant 38 puis le composant 42 à l'ensemble 38-40 et enfin le composant 44 à l'ensemble 38-40-42 par le procédé objet de l'invention, ce qui est notamment intéressant dans le cas où l'on souhaite ajouter un composant à une structure déjà existante, soit en empilant les composants 38, 40, 42 et 44 et en réalisant une interconnexion collective, ce qui constitue une technique plus simple.

Une autre structure est réalisable conformément à l'invention (figure 8) et comporte un composant de grande taille 46 auquel sont interconnectés plusieurs composants 48, 50, 52. Une telle structure peut être réalisée soit en répétant le procédé de l'invention pour interconnecter successivement les composants 48, 50 et 52 au composant 46, soit en réalisant une interconnexion collective des composants 46, 48, 50 et 52 conformément au procédé de l'invention.

Pour la structure représentée sur la figure 8, on notera l'intérêt de l'auto-alignement que procure l'invention. On notera également que, pour la même structure réalisée par le premier procédé connu mentionné plus haut (répété plusieurs fois), le positionnement d'un composant tel que 48 est indépendant du positionnement des autres composants 50, 52, ce qui implique que la précision du positionnement de l'ensemble 48-50-52 est la somme des précisions correspondant aux positionnements individuels du composant 48, du composant 50 et du composant 52. Au contraire, pour la structure représentée sur la figure 8 et réalisée conformément à l'invention, le positionnement de chaque composant 48, 50 ou 52 dépend des positions relatives des plots du composant 46 auquel ces composants 48, 50 et 52 doivent être associés, d'où une inter-dépendance des positionnements des composants 48, 50 et 52 et par conséquent une précision globale de positionnement qui peut être meilleure que la précision obtenue avec le premier procédé connu mentionné plus haut.

On notera aussi que la structure représentée sur la figure 8 ne pourrait être réalisée avec ce premier procédé connu et que, lorsqu'elle est réalisée conformément à l'invention, il est préférable, lorsqu'il y a beaucoup de composants, de maintenir (horizontalement) celui des composants qui a le plus d'interconnexions, les autres composants étant libres et disposés, dans l'ordre voulu, au-dessus de ce composant.

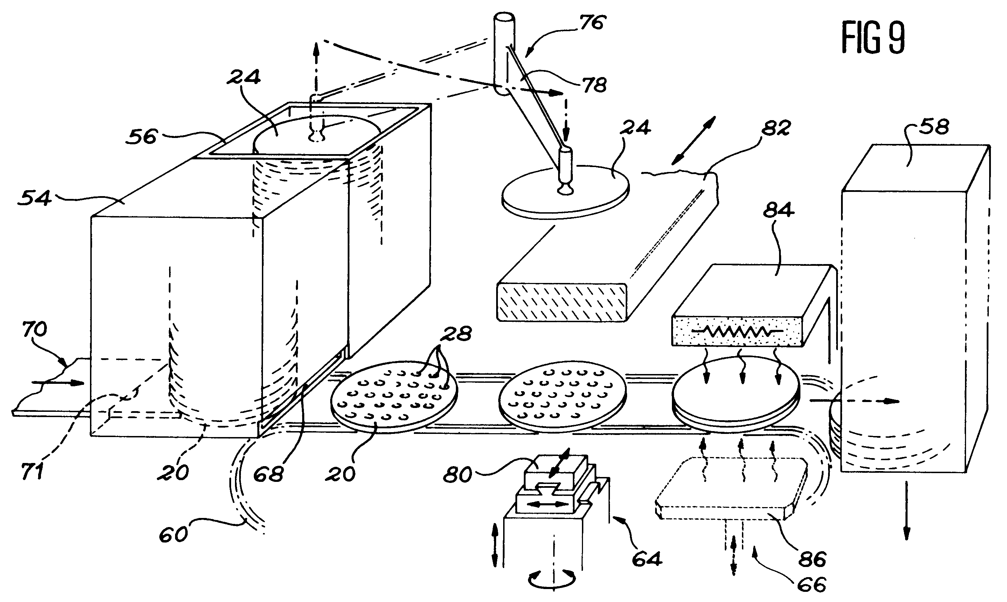

Sur la figure 9, on a représenté schématiquement un mode de réalisation particulier de la machine objet de l'invention.

La machine représentée sur la figure 9 permet d'interconnecter deux composants qui peuvent être des substrats de grande surface, par exemple deux tranches entières de silicium. Cette machine comprend un premier conteneur 54 dans lequel sont empilés verticalement les composants 20 préalablement munis des galettes d'indium 28 de telle manière que la face de chaque composant portant ces galettes soit tournée vers le haut du conteneur 54, et un deuxième conteneur 56 qui est disposé à côté du conteneur 54 et qui contient les composants 24 empilés verticalement de telle manière que les plots de ces composants, qui sont destinés à être connectés aux galettes d'indium, soit tournés vers le bas du conteneur 56.

La machine comprend également un troisième conteneur 58 qui est éloigné des conteneurs 54 et 56 et qui est destiné à recevoir les assemblages de composants 20 et 24.

La machine représentée sur la figure 9 comprend aussi des moyens 60 de transfert permettant la circulation horizontale de composants du conteneur 54 jusqu'au conteneur 58, des moyens 64 permettant l'alignement des composants 20 et 24 et des moyens 66 de chauffage de l'assemblage de ces composants.

Les moyens de transfert 60, connus dans l'état de la technique, permettent de transporter le composant 20 jusqu'à ce qu'il soit assemblé au composant 24 puis, de là, l'assemblage obtenu jusqu'au conteneur 58 prévu pour recevoir cet assemblage.

Le conteneur 54 comporte, à sa base et en regard des moyens de transfert 60, une fente 68 permettant le passage des composants 20 un à un. Des moyens 70 sont prévus pour pousser, à travers cette fente et sur les moyens de transfert, le composant 20 qui est le plus bas dans la pile. A cet effet, les moyens 70 peuvent comprendre un poussoir prévu pour traverser préalablement une autre fente 71 opposée à ladite fente.

Pendant le transfert du composant 20 jusqu'aux moyens 64, le composant 24 le plus haut dans la pile correspondante est transféré en position d'alignement par des moyens 76 prévus à cet effet qui peuvent comprendre un bras de préhension à vide 78. Le composant 24 convenablement positionné pour cet alignement est maintenu en position d'attente grâce à ce bras 78.

Lorsque le composant 20 arrive au niveau des moyens 64, les moyens de transfert 60 sont arrêtés. Ces moyens 64 comprennent un support 80 déplaçable verticalement et suivant deux directions perpendiculaires et horizontales, le support 80 étant également capable de tourner autour d'un axe vertical.

Les moyens de transfert 60 se présentent, de façon très schématique, sous la forme de deux rails mobiles, aptes à supporter le composant 20, ces deux rails mobiles étant aptes à laisser passer entre eux le support 80.

Les moyens 64 comprennent également un système à double visée 82 (vers le haut et vers le bas). Ce système est interposé entre les composants 20 et 24 en vue de réaliser leur alignement puis escamoté lorsque cet alignement est obtenu.

Le composant 20 étant arrêté au niveau des moyens 64, le support 80 est déplacé vers le haut jusqu'à ce qu'il soulève légèrement le composant 20 des moyens de transfert 60 puis l'alignement optique des composants 20 et 24 est réalisé grâce au système 82 et grâce à des mouvements appropriés du support 80, après quoi le système 82 est escamoté, le composant 24 est descendu jusqu'à être en contact avec le composant 20, grâce à un mouvement vertical descendant des moyens 76 qui libèrent alors ce composant 24 lorsqu'il est en contact avec le composant 20. Ensuite, le support 80 est abaissé jusqu'à ce que l'assemblage obtenu soit en contact avec les moyens de transfert 60. L'alignement est de préférence réalisé à moins de 10 micromètres près.

L'assemblage obtenu est ensuite transféré vers les moyens de chauffage 66 prévus pour atteindre la température de fusion de l'indium.

Les moyens de chauffage 66 peuvent comprendre un four 84 du type four à passage à lampes halogènes avec réflecteur (non représentés). Ce four est commandé pour porter l'assemblage qui circule à travers ledit four à la température voulue en le temps voulu, après quoi l'assemblage est refroidi naturellement pendant son transfert jusqu'au conteneur 58.

En variante, le four 84 est remplacé par une table chauffante 86 disposée en-dessous des moyens de transfert 60 et mobile verticalement. Cette table 86 a une très grande inertie par rapport à l'assemblage obtenu de manière à ne pas perturber l'alignement relatif entre les deux composants. La table 86 traverse les moyens de transfert 60 prévus à cet effet comme on l'a expliqué à propos du support 80, de façon que cette table 86 vienne s'appliquer contre la face libre de l'assemblage obtenu pendant le temps voulu pour porter celui-ci à la température souhaitée, après quoi la table 86 redescend. Comme précédemment, l'assemblage est ensuite refroidi naturellement pendant qu'il est transféré vers le conteneur de rangement 58.

On notera que l'approvisionnement par conteneur ou cassette ainsi que le transfert poste à poste de tranches de silicium sont des moyens déjà utilisés sur des équipements courants de fabrication de circuits intégrés.

L'alignement optique à ± 10 micromètres près est déjà utilisé dans le domaine de la Microélectronique et notamment sur des machines de découpe sur tranche. L'adaptation à la présente invention de tels systèmes d'alignement optique est réalisable par l'homme du métier car, dans la présente invention, l'alignement n'a pas besoin d'être rigoureux puisque le phénomène d'auto-alignement permet ultérieurement cet alignement rigoureux.

De même, le four et la table chauffante, qui permettent de fournir une énergie homogène sur une grande surface et permettent à l'assemblage d'atteindre une température définie à ± 5°C, sont connus dans le domaine de la Microélectronique.

La machine décrite en référence à la figure 9 permet bien entendu de réaliser des structures du genre de celle qui est représentée sur la figure 8. Pour ce faire, le composant 46 est transporté par les moyens de transfert 60 et les composants 48, 50 et 52 rangés dans une ou plusieurs cassettes, sont successivement placés au contact du composant 46 grâce à des alignements optiques répétés. L'interconnexion a donc lieu collectivement.

Bien entendu, on pourrait réaliser des interconnexions successives en réalisant plusieurs passages successifs dans la machine de la figure 9.

Il est également possible de réaliser une structure du genre de celle qui est représentée sur la figure 7 grâce à la machine de la figure 9. A cet effet, on peut réaliser des interconnexions successives grâce à des passages successifs dans la machine, de manière à constituer progressivement l'empilement ou réaliser une interconnexion collective. A cet effet, l'un des composants d'extrémité de l'empilement, muni de galettes 28, est transféré par les moyens 60 en position d'alignement pour recevoir le composant adjacent de la pile. L'empilement obtenu peut d'une manière identique recevoir un troisième composant et ainsi de suite jusqu'à l'obtention de l'empilement complet qui est ensuite transféré vers les moyens de chauffage où l'interconnexion proprement dite à lieu, après quoi l'empilement est rangé dans une cassette.

## Revendications

1. Procédé d'interconnexion d'un premier composant électrique (20) et d'au moins un deuxième composant électrique (24) qui sont respectivement munis de plots de contact électrique (22, 26) destinés à être interconnectés, ce procédé comprenant une étape dans laquelle chaque plot du premier composant est recouvert d'un élément de soudure appelé galette, qui est électriquement conducteur (28) et qui s'étend sur l'environnement dudit plot, ces galettes ayant une épaisseur sensiblement constante et étant faites d'un matériau métallique à bas point de fusion, soudable aux plots du premier composant, ceux-ci étant mouillables par ce matériau à l'état fondu alors que leur environnement sur le premier composant ne l'est pas, ledit matériau étant également soudable aux plots du deuxième composant, en ce que ces derniers plots étant mouillables par ce matériau à l'état fondu alors que leur environnement sur le deuxième composant ne l'est pas et en ce que le procédé comprenant en outre les étapes suivantes :
- le premier et le deuxième composants sont mis en contact de telle manière que les galettes du premier composant recouvrent totalement ou partiellement les plots correspondants du deuxième composant,
- l'assemblage des premier et deuxième composants ainsi obtenu est porté à une température permettant la fusion du matériau métallique des galettes, l'un des premier et deuxième composants étant maintenu tandis que l'autre est libre, et
- la température de l'assemblage est ramenée en-dessous de la température de fusion du matériau métallique.

2. Procédé selon la revendication 1, caractérisé en ce que l'interconnexion est effectuée sur un ensemble (38, 40, 42, 44) de plus de deux composants à la fois, de façon collective, en vue d'obtenir un empilement de ces composants, chaque composant interne de l'empilement étant muni de plots de contact électrique sur ses deux faces, en ce que les composants de l'ensemble sont empilés, des galettes faites dudit matériau étant préalablement prévues sur les plots de composants appropriés de l'ensemble, à raison d'une seule galette pour chaque couple de plots à interconnecter, de telle manière que les contacts électriques voulus puissent être établis entre les plots des composants de l'empilement, et en ce que cet empilement est porté à ladite température, l'un des composants d'extrémité de l'empilement étant maintenu horizontalement tandis que les autres composants de l'empilement sont libres et se trouvent au-dessus de ce composant d'extrémité.

3. Procédé selon la revendication 1, caractérisé en ce que l'interconnexion est effectuée sur un ensemble de plus de deux composants à la fois, de façon collective, l'un (46) des composants étant destiné à être interconnecté aux autres (48, 50, 52) par l'une de ses faces, en ce que l'assemblage des composants est réalisé, des galettes faites dudit matériau étant préalablement prévues sur les plots de composants appropriés de l'ensemble, à raison d'une seule galette pour chaque couple de plots à interconnecter, de telle manière que les contacts électriques voulus puissent être établis entre les plots des composants de l'assemblage, et en ce que cet assemblage est porté à ladite température, le composant destiné à être connecté aux autres composants étant maintenu horizontalement tandis que les autres composants de l'assemblage sont libres et se trouvent au-dessus dudit composant.

4. Procédé selon l'une quelconque des revendications 1 à 3, caractérisé en ce qu'après la mise en contact des composants jusqu'au refroidissement de ceux-ci en-dessous de la température de fusion du matériau métallique constituant les galettes, l'un des composants est maintenu horizontalement tandis que chaque autre composant est libre et se trouve au-dessus du composant maintenu horizontalement.

5. Procédé selon l'une quelconque des revendications 1 à 4, caractérisé en ce que le matériau métallique est choisi dans le groupe comprenant l'étain, l'indium, le plomb et les alliages métalliques à bas point de fusion, contenant de l'étain, de l'indium ou du plomb.

6. Machine d'interconnexion d'un premier composant (20) et d'au moins un deuxième composant (24) qui sont respectivement munis de plots de contact électrique destinés à être interconnectés, cette machine étant caractérisée en ce qu'elle comprend :
- des moyens (54, 56) d'approvisionnement en premier et deuxième composants, dans lesquels des galettes électriquement conductrices recouvrent les plots de composants, en débordant sur l'environnement de ces plots, ces composants munis de galettes étant choisis pour qu'il y ait une seule galette pour chaque couple de plots à interconnecter, ces galettes étant faites d'un matériau métallique à bas point de fusion, soudable aux plots des composants, ceux-ci étant mouillables par ce matériau à l'état fondu alors que leur environnement sur les composants correspondants ne l'est pas,
- des moyens (58) de réception des composants interconnectés,
- des moyens (64) d'alignement des composants, prévus pour mettre en contact les galettes de chaque composant choisi avec les plots du composant à connecter à ce composant choisi,
- des moyens (66) de chauffage prévus pour porter l'assemblage que constitue les composants mis en contact à une température permettant la fusion du matériau, et
- des moyens (60) de transfert de composants depuis les moyens d'approvisionnement jusqu'aux moyens de réception en passant par les moyens d'alignement et les moyens de chauffage.

7. Machine selon la revendication 6, caractérisée en ce que les moyens d'alignement (64) comprennent :
- des moyens optiques (82) permettant l'observation des faces de composants, faces qui sont à interconnecter, et
- des moyens (80) de déplacement relatif de ces composants.

8. Machine selon l'une quelconque des revendications 6 et 7, caractérisée en ce que les moyens de chauffage (66) comprennent un four à passage (84), destiné à être traversé par les composants mis en contact.

9. Machine selon l'une quelconque des revendications 6 et 7, caractérisée en ce que les moyens de chauffage (66) comprennent une table chauffante mobile (86), prévue pour être appliquée contre l'assemblage des composants puis écartée de cet assemblage.

## Patentansprüche

1. Verfahren zur Verbindung eines ersten elektrischen Bauteils (20) und wenigstens eines zweiten elektrischen Bauteils (24), die jeweils versehen sind mit elektrischen Kontaktelementen (22, 26), dazu bestimmt, miteinander verbunden zu werden, wobei dieses Verfahren einen Schritt umfaßt, in dem jedes Kontaktelement des ersten Bauteils bedeckt ist durch ein Lötteil, genannt Kontaktplatte (28), das elektrisch leitend ist und sich über die Umgebung des genannten Kontaktelements erstreckt, wobei diese Kontaktplatten eine im wesentlichen konstante Dicke haben und aus einem metallischen Material mit niedrigem Schmelzpunkt bestehen, verlötbar mit den Kontaktelementen des ersten Bauteils, wobei diese benetzbar sind durch dieses Material im geschmolzenen Zustand, während ihre Umgebung es nicht ist, wobei das genannte Material sich ebenfalls mit den Kontaktelementen des zweiten Bauteils verlöten läßt, dadurch, daß diese letzteren Kontaktelemente benetzbar sind durch dieses Material im geschmolzenen Zustand, während ihre Umgebung auf dem zweiten Bauteil es nicht ist, und dadurch, daß das Verfahren außerdem die folgenden Schritte umfaßt:
- das erste und das zweite Bauteil werden so in Kontakt gebracht, daß die Kontaktplatten des ersten Bauteils die entsprechenden Kontaktelemente des zweiten Bauteils ganz oder teilweise bedecken,
- der so hergestellt Verband aus dem ersten und dem zweiten Bauteil wird auf eine Temperatur gebracht, die das Schmelzen des metallischen Materials der Kontaktplatten bewirkt, wobei eines der Bauteile, das erste oder das zweite, festgehalten wird, während das andere frei ist, und
- die Temperatur des Verbands wird zurückgeführt unter die Schmelztemperatur des metallischen Materials.

2. Verfahren nach Anspruch 1, dadurch gekennzeichet, daß die Verbindung hergestellt wird bei einem Aufbau (38, 40, 42, 44) von mehr als zwei Bauteilen auf einmal, gemeinsam, um einen Stapel dieser Bauteile zu erhalten, wobei jedes Bauteil innerhalb des Stapels auf seinen beiden Seiten versehen ist mit elektrischen Kontaktelementen, dadurch, daß die Bauteile des Aufbaus gestapelt sind, vorhergehend Kontaktplatten, hergestellt aus dem genannten Material, angebracht werden auf den Kontaktelementen der zu dem Aufbau gehörenden Bauteile, mit einer einzigen Kontaktplatte für jedes zu verbindende Kontaktelementepaar, so daß die gewünschten elektrischen Kontakte hergestellt werden können zwischen den Kontaktelementen der Bauteile des Aufbaus, und dadurch, daß dieser Stapel auf die genannte Temperatur gebracht wird, wobei eines der Endbauteile des Stapels horizontal festgehalten wird, während die anderen Bauteile des Stapels frei sind und sich über diesem Endbauteil befinden.

3. Verfahren nach Anspruch 1, dadurch gekennzeichet, daß die Verbindung hergestellt wird bei einem Aufbau von mehr als zwei Bauteilen auf einmal, gemeinsam, wobei eines (46) der Bauteile dazu bestimmt ist, mit den anderen (48, 50, 52) durch eine seiner Seiten verbunden zu werden, dadurch, daß der Verband der Bauteile hergestellt wird, wobei Kontaktplatten, hergestellt aus dem genannten Material, vorher angebracht werden auf den entsprechenden Kontaktelementen des Aufbaus, eine Kontaktplatte für jedes zu verbindende Kontaktelementepaar, so daß die gewünschten elektrischen Kontakte hergestellt werden können zwischen den Kontaktelementen der Bauteile des Verbands, und dadurch, daß dieser Verband auf die genannte Temperatur gebracht wird, das Bauteil, das dazu bestimmt ist, mit den anderen Bauteilen verbunden zu werden, horizontal festgehalten wird, während die anderen Bauteile des Verbands frei sind und sich über dem genannten Bauteil befinden.

4. Verfahren nach einem der Ansprüche 1 bis 3, dadurch gekennzeichet, daß nach der Kontaktherstellung der Bauteile bis zu deren Abkühlung unter die Schmelztemperatur des die Kontaktplatten bildenden metallischen Materials eines der Bauteile horizontal festgehalten wird, wohingegen jedes andere Bauteil frei ist und sich über dem horizontal festgehaltenen Bauteil befindet.

5. Verfahren nach einem der Ansprüche 1 bis 4, dadurch gekennzeichet, daß das metallische Material gewählt wird aus der Gruppe, die das Zinn, das Indium, das Blei umfaßt und die Metallegierungen mit niedrigem Schmelzpunkt, die Zinn, Indium oder Blei enthalten.

6. Vorrichtung zur Verbindung eines ersten Bauteils (20) mit wenigstens einem zweiten Bauteil (24), die jeweils versehen sind mit elektrischen Kontaktelementen, dazu bestimmt, miteinander verbunden zu werden, wobei diese Vorrichtung dadurch gekennzeichnet ist, daß sie umfaßt:
- Zuführungseinrichtungen (54, 56) für erste und zweite Bauteile, bei denen elektrisch leitende Kontaktplatten die Bauteile-Kontaktelemente bedecken, dabei vorstehend über die Umgebung dieser Kontaktelemente, wobei diese mit Kontaktplatten versehenen Bauteile so gewählt werden, daß es eine einzige Kontaktplatte für jedes zu verbindende Kontaktelementepaar gibt, wobei diese Kontaktplatten hergestellt sind aus einem metallischen Material mit niedrigem Schmelzpunkt, verlötbar mit den Bauteile-Kontaktelementen, wobei diese benetzbar sind durch dieses Material im geschmolzenen Zustand, wohingegen ihre Umgebung auf den entsprechenden Bauteilen es nicht ist,
- Aufnahmeeinrichtungen (58) der verbundenen Bauteile,
- Ausrichtungseinrichtungen (64) der Bauteile, vorgesehen, um die Kontaktplatten jedes gewählten Bauteils mit den Kontaktelementen des Bauteils in Berührung zu bringen, das mit diesem gewählten Bauteil verbunden werden soll,
- Heizeinrichtungen (66), vorgesehen um den Verband, den die in Berührung gebrachten Bauteile bilden, auf eine Temperatur zu bringen, die das Schmelzen des Materials gewährleistet, und
- Transfereinrichtungen (60) der Bauteile von den Zuführungseinrichtungen bis zu den Aufnahmeeinrichtungen, die die Ausrichtungseinrichtungen und die Heizeinrichtungen durchlaufen.

7. Vorrichtung nach Anspruch 6, dadurch gekennzeichet, daß die Ausrichtungseinrichtungen umfassen:
- optische Einrichtungen (82), die die Beobachtung der zu verbindenden Bauteileflächen ermöglichen, und
- Relativ-Verschiebungseinrichtungen (80) dieser Bauteile.

8. Vorrichtung nach einem der Ansprüche 6 und 7, dadurch gekennzeichet, daß die Heizeinrichtungen (66) einen Durchlaufofen (84) enthalten, dazu bestimmt, von den in Berührung gebrachten Bauteilen durchlaufen zu werden.

9. Vorrichtung nach einem der Ansprüche 6 und 7, dadurch gekennzeichet, daß die Heizeinrichtungen (66) einen beweglichen Heiztisch (86) enthalten, vorgesehen, um gegen den Bauteileverband gedrückt und dann von diesem Verband entfernt zu werden.

## Claims

1. Method to interconnect a first electric component (20) and at least a second electric component (24) which are respectively provided with electric contact blocks (22, 26) intended to be interconnected, this method including a stage in which each block of the first component is covered with a welding element, known as a wafer, which is electrically conductive (28) and which extends over the environment of said block, these wafers having an approximately constant thickness and being made of a low melting point metallic material able to be welded to the blocks of the first component, these blocks being wettable by this material when in its molten state, whereas their environment concerning the first component is not wettable, material is also being weldable to the blocks of the second component, in that these latter blocks are wettable by this material when in its molten state, whereas their environment concerning the second component is not wettable, and in that the method further includes the following stages:
- the first and second components are placed in contact so that the wafers of the first component totally or partly cover the corresponding blocks of the second component,
- the assembly thus obtained of the first and second components is heated to a temperature able to melt the metallic material of the wafers, one of the first and second components being maintained, whereas the other is free, and
- the temperature of the assembly is reduced below the melting temperature of the metallic material.

2. Method according to claim 1, characterized in that the interconnection is effected on an assembly (38, 40, 42, 44) of more than two components collectively at the same time so as to obtain a stacking of these components, each internal component of the stacking being provided with electric contact blocks on its two faces, in that the components of the assembly are stacked, wafers made of said material being previously provided on the appropriate component blocks of the assembly at the rate of one wafer for each pair of blocks to be interconnected so that the desired electric contacts may be established between the blocks of the components of the stacking, and that this stacking is heated to said temperature, one of the extremity components of the stacking being maintained horizontally, whereas the other components of the stacking are free and are above this extremity component.

3. Method according to claim 1, characterized in that the interconnection is effected on an assembly of more than two components collectively at the same time, one (46) of the components being intended to be interconnected to the others (48, 50, 52) via one of its faces, that the assembly of the components is embodied from wafers made of said material previously having been provided on the appropriate component blocks of the assembly at the rate of one wafer for each pair of blocks to be interconnected so that the desired electric contacts are able to be established between the blocks of the components of the assembly, and that this assembly is heated to said temperature, the component intended to be connected to the other components being maintained horizontally, whereas the other components of the assembly are free and are above said component.

4. Method according to any one of the claims 1 to 3, characterized in that after the placing in contact of the components until they have been cooled below the melting temperature of the metallic material constituting the wafers, one of the components is maintained horizontally, whereas each other component is free and is above the component maintained horizontally.

5. Method according to any one of the claims 1 to 4, characterized in that the metallic material is selected from the group consisting of tin, indium, lead and low melting point metallic alloys containing tin, indium or lead.

6. Machine for the interconnection of a first component (20) and at least one second component (24), which are respectively provided with electrical contact blocks which are to be interconnected, said machine being characterized in that it comprises:
- means (54, 56) for supplying first and second components, in which the electrically conductive wafers cover the component blocks and project over the environment of the said blocks, said components provided with wafers being chosen so that there is a single wafer for each pair of blocks to be interconnected, said wafers being made from a metallic material having a low melting point and weldable to the blocks of the components, the latter being wettable by said material in the molten state, whereas their environment on the corresponding components is not wettable,
- means (58) for receiving the interconnected components,
- means (64) for the alignment of the components for contacting the wafers of each chosen component with the blocks of the components to be connected to said chosen component,
- heating means (66) for raising the assembly formed by the contacted components to a temperature permitting the melting of the material and
- means (60) for the transfer of components from the supply means to the reception means, passing via the alignment means and the heating means.

7. Machine according to claim 6, characterized in that the alignment means (64) incorporate optical means (82) permitting the observation of the faces of the components and which are to be interconnected and means (80) for the relative displacement of said components.

8. Machine according to either of the claims 6 and 7, characterized in that the heating means (66) incorporate a passage furnace (84) to be traversed by the contacted components.

9. Machine according to either of the claims 6 and 7, characterized in that the heating means (66) incorporate a mobile heating table (86) for application to the assembly of components and then movement away from said assembly.
